# EUROPEAN PATENT APPLICATION

(11) **EP 4 535 404 A1**
(43) Date of publication of application: **09.04.2025**
(21) Application number: 23201873.9
(22) Date of filing: 05.10.2023
(51) Int. Cl.: H01L 21/3115, H01L 29/51

(54) **A METHOD FOR FORMING A GATE DIALELECTRIC AND A GATE DIELECTRIC FOR A SEMICONDUCTOR DEVICE**

(71) Applicant: Imec VZW, 3001 Leuven (BE)
(72) Inventor: ARIMURA, Hiroaki, 3000 Leuven (BE)
(74) Representative: AWA Sweden AB

(57) **Abstract**

The present invention provides a method for forming a gate dielectric (100) for a semiconductor device, the method comprising forming an interfacial layer (102a-b), being a layer of dielectric material, forming a bottom high-k dielectric layer (104a-b) on top of the interfacial layer (102a-b); forming a first diffusion source layer (106a-b), being a layer comprising metal atoms, on top of the bottom high-k dielectric layer (104a-b); forming a first capping layer (108a-b) on top of the first diffusion source layer (106a-b); performing a first anneal such that metal atoms of the first diffusion source layer (106a-b) diffuse into the bottom high-k dielectric layer (104a-b); removing the first capping layer (108a-b) after the first anneal; and forming, after removing the first capping layer (108a-b), a top high-k dielectric layer (120a-b) on top of the bottom high-k dielectric layer (104a-b). The present invention also provides a gate dielectric (100) for a semiconductor device.

## Description

### TECHNICAL FIELD

The present disclosure relates to a method for forming a gate dielectric for a semiconductor device and to a gate dielectric for a semiconductor device.

### BACKGROUND

A gate dielectric of a semiconductor device, e.g. a metal-oxide-semiconductor field-effect transistor (MOSFET), is the dielectric between the semiconductor and the gate electrode. The gate dielectric may comprise a high-k dielectric layer. The voltage at which the semiconductor device (e.g. MOSFET) turns on, is called the threshold voltage (Vt). There are various ways to control Vt. One way to control Vt is to diffuse metal atoms into the high-k dielectric layer and thereby control the effective work function (EWF).

### SUMMARY

It is an objective of the present inventive concept to provide a method for forming a high quality gate dielectric for a semiconductor device. A further objective is to provide a gate dielectric for a semiconductor device which provides a low Vt. A further objective is to provide a gate dielectric for a semiconductor device which provides a low gate leakage current of the semiconductor device. Further and alternative objectives may be understood from the following.

According to a first aspect of the invention, there is provided a method for forming a gate dielectric for a semiconductor device, the method comprising:
forming an interfacial layer, being a layer of dielectric material, on top of a semiconductor layer;
forming a bottom high-k dielectric layer on top of the interfacial layer, the interfacial layer being in-between the bottom high-k dielectric layer and the semiconductor layer, the interfacial layer and the bottom high-k dielectric layer comprising different materials;
forming a first diffusion source layer, being a layer comprising metal atoms, on top of the bottom high-k dielectric layer;
forming a first capping layer on top of the first diffusion source layer;
performing a first anneal such that metal atoms of the first diffusion source layer diffuse into the bottom high-k dielectric layer;
removing the first capping layer after the first anneal; and
forming, after removing the first capping layer, a top high-k dielectric layer on top of the bottom high-k dielectric layer.

The semiconductor layer may be the intended channel of the semiconductor device, e.g. the channel between the source and drain of the semiconductor device. The semiconductor device may herein be a transistor, e.g. a MOSFET. The interfacial layer may comprise an oxide, e.g.silicon oxide and/or silicon oxynitride. The bottom high-k dielectric layer may comprise a high-k dielectric oxide e.g. hafnium oxide or zirconium oxide or hafnium zirconium oxide_{.} The metal atoms of the first diffusion source layer may comprise dipole formation metals, e.g. Lanthanum (La) or Aluminium (Al). To exemplify, the first diffusion source layer may comprise La₂O₃ or Al₂O₃. The first anneal may be called drive-in anneal or diffusion anneal.

The metal atoms of the first diffusion source layer may, when diffused into the bottom high-k dielectric layer, provide an interface dipole region at an interface between the bottom high-k dielectric layer and the interfacial layer. Thus, the metal atoms may tune the effective work function towards the band-edge of the semiconductor bandgap and thereby also reduce Vt.

It is a realization that a top high-k dielectric layer on top of the bottom high-k dielectric layer, according to the above, provides a high quality gate dielectric. The bottom high-k dielectric layer may be thin, e.g. thinner than the total thickness of the high-k dielectrics (which may be the sum of the bottom and top high-k dielectric layer thicknesses). Thus, the metal atoms may only need to be driven through a thin high-k dielectric layer. In contrast, when using conventional methods for forming a gate dielectric, metal atoms may need to be driven through a thick high-k dielectric layer. The method provides the following advantages:
The method facilitates a small gate leakage current. It is a realization that drive-in anneal of metal atoms through a thick high-k dielectric layer may require high temperature and/or long anneal time in order for the metal atoms to diffuse through the thick high-k dielectric layer, especially in cases where the high-k dielectric layer has a limited diffusivity. Such a high-temperature drive-in anneal can cause crystallization, or at least some local crystallization, of the high-k dielectric layer which in turn results in an increased gate leakage current. Thus, by diffusing the metal atoms through the bottom high-k dielectric layer, rather than through the entire thickness of the high-k dielectrics, a drive-in anneal having a low temperature and/or short anneal time may be used. Consequently, a small gate leakage current may be achieved.

Further, the method facilitates a small Vt. More metal atoms may reach the interface between the bottom high-k dielectric layer and the interfacial layer when diffusing through a thin high-k dielectric layer as compared to when diffusing through a thick high-k dielectric layer. Thus, a large EWF shift may be achieved, even when the drive-in anneal is performed at a low temperature and/or short anneal time, thereby facilitating a small Vt.

In accordance with the above-mentioned method, by forming both a bottom high-k dielectric and a top high-k dielectric layer on top of the bottom high-k dielectric, the bottom high-k dielectric may be dimensioned to allow for the first diffusion source layer to diffuse into the bottom high-k dielectric layer by means of a low thermal budget drive-in anneal. Such a low thermal budget drive-in anneal, as opposed to a high thermal budget drive-in anneal, ensures that the risk of crystallization of the bottom high-k dielectric layer is reduced and thereby the gate leakage current may also be reduced. Furthermore, there is provided an interface dipole region between the bottom high-k dielectric layer and the interfacial layer hence enabling a shifting of the EWF and thereby a low threshold voltage Vt is obtained.

The formation of the first capping layer on top of the first diffusion source layer may facilitate the drive-in anneal while protecting the underlying semiconductor device structure in any subsequent processing steps. The first capping layer may e.g. prevent diffusion of any material on top of the first capping layer into the underlying structure. It may also prevent evaporation of the diffusion source layer, thus ensuring that a large amount of metal atoms may diffuse into the interface between the bottom high-k dielectric layer and the interfacial layer. The capping layer may also serve to mitigate issues with surface morphology of the layers of the layer stack. The first capping layer may be formed of a layer comprising TiN.

It may in this context be noted that the gate dielectric may be intended to be formed on a semiconductor device which includes, for instance, a conventional field effect transistor (FET) device.

It may in this context be further noted that the bottom high-k dielectric layer may have a thickness in the range of 0.5 nm to 1.5 nm.

The formation of a top high-k dielectric layer on top of the bottom high-k dielectric layer provides a dielectric layer having such a total thickness to enable a reduced gate leakage current.

By dimensioning the bottom high-k dielectric layer in the above-mentioned manner, the first diffusion source layer may diffuse into the bottom high-k dielectric and thus reach the interface between the bottom high-k dielectric layer and the interfacial layer by means of a low thermal budget drive-in anneal regardless should the bottom high-k dielectric have a relatively limited diffusivity.

It may in this context be further noted that the bottom high-k dielectric layer and the top high-k dielectric layer are preferably formed of the same material. Thus, the bottom high-k dielectric layer and the top high-k dielectric layer may form a homogeneous dielectric layer having a substantially uniform composition. Alternatively, the bottom high-k dielectric layer and the top high-k dielectric layer may be formed of the same material

It may in this context be further noted that while forming an interface dipole on the interfacial layer is possible prior to forming the bottom high-k dielectric layer thereon, this may be result in regrowth and surface damage of the interfacial layer in any subsequent processing steps. Thus, this method is advantageous in that by forming an interface dipole by diffusing metal atoms into the bottom high-k dielectric layer as opposed to forming an interface dipole directly on the interfacial layer, surface damage of the interfacial layer may be obviated and thereby the performance of the semiconductor may be improved.

A comparably high quality interfacial layer may be obtained with this method. As such, the interfacial layer may serve as an adequate template for any subsequent epitaxial layer growth.

Furthermore, an interface dipole formed directly on the interfacial layer may be exposed to the ambient and thereby react with the moisture in the ambient. This could potentially impact the bonding between the dipole-forming atoms and the host atoms of the interfacial layer, and thus affect the semiconductor device performance.

It may in this context be further noted that the above-mentioned method may be applied to the gate-first technology. In accordance with the above-mentioned method, a gate dielectric for a semiconductor device, such as a CMOSFET, may be formed. A conventional CMOSFET may comprise an n-type FET (NFET) and a p-type FET (PFET). In the case of the gate-first technology, a gate, usually a metal gate, of the NFET and the PFET is etched simultaneously during the formation of the CMOSFET. Thus, it is preferred that both of the NFET and the PFET have the same gate. However, it is implied that the EWF of either the NFET or the PFET, or both of them, is off from a respective target and hence needs to be shifted by a respective interface dipole. Alternatively, the above-mentioned method may be applied to the gate-last technology.

By the term "thermal budget" it is herein meant the product of an annealing temperature and an annealing time.

By the term "layer stack" it is herein meant the stack of layers of the gate dielectric.

In the context of the present disclosure, a layer being "provided on" another layer generally refers to that the layer is arranged "below" the other layer. Thereby, the terms "below"/"above" or "bottom"/"top" relate to layers of the material stack, in particular to the fabrication/growth direction of these layers. In any case, "provided on" means that the layer is in contact with the other layer. For instance, the layer may be (epitaxially) grown on the other layer.

The first aspect of the invention is based on the insight that depositing a high-k dielectric layer in two steps, wherein a first step comprises forming a first diffusion source layer on a comparably thin bottom high-k dielectric layer and performing a drive-in anneal to form an interface dipole, and wherein a second step comprises subsequently forming a top high-k dielectric layer on top of the bottom high-k dielectric layer hence resulting in a reduced gate leakage current and an improved tunability of the threshold voltage Vt. As such, the performance of the semiconductor device is improved. Furthermore, crystallization of the high-k dielectric layer during e.g. drive-in anneal may also be dependent on the thickness thereof. A comparably thick high-k dielectric layer may have a tendency to crystallize easier for a given thermal budget. Thus, by depositing a comparably thin bottom high-k dielectric layer, said layer may be less susceptible to crystallization for a given thermal budget during the drive-in anneal. A comparably thin top high-k dielectric layer may also be deposited during the subsequent processing steps, which layer may also be less susceptible to crystallization for a given thermal budget during any subsequent heat treatments. Thus, there is provided greater leeway in choosing the thermal budget while minimizing the risk of crystallization of the high-k dielectric layer.

The interfacial layer may comprise silicon oxide and/or silicon oxynitride.

Silicon oxide generally refers to either silicon dioxide (SiO₂) and/or silicon monoxide (SiO). Silicon oxynitride (SiOₓN_{y}) possesses high durability at high temperature, high resistance to thermal-shock and oxidation, high density, excellent mechanical performance, and a low dielectric constant. Nitridation of an interfacial layer comprising silicon oxide may also stabilize the interfacial layer, and results in the formation of a silicon oxynitride interfacial layer. Said stabilization enables the interfacial layer to better withstand any subsequent processing steps.

The bottom and/or top high-k dielectric layer may comprise hafnium oxide or zirconium oxide or hafnium zirconium oxide.

Hafnium oxide and zirconium oxide are high-k materials and may serve to reduce the gate leakage current. Each of these materials have a comparably low equivalent oxide thickness (EOT). This enables an increased device performance. Hafnium oxide may be HfO₂. Zirconium oxide may be ZrO₂. It is conceivable that the bottom and/or top high-k dielectric layer may comprise HfSiON. HfSiON is a thermally stable material and has a comparably high tolerance against crystallization during a drive-in anneal and thereby the gate leakage current can be suppressed further. Alternatively, the high-k dielectric layer may comprise hafnium silicate, zirconium silicate, aluminium oxide, titanium oxide, yttrium oxide, among others.

A thickness of the bottom high-k dielectric layer may be below 1.5 nm.

By way of example, the bottom high-k dielectric layer may be below 1.2 nm, or below 1.0 nm. In general, the thickness of the bottom high-k dielectric layer may be between 0.5 nm and 1.5 nm. For instance, the thickness may be 0.8 nm, 0.9 nm, or 1.0 nm. Such a thickness of the bottom high-k dielectric layer allows for a high amount of metal atoms to diffuse into the interface between the bottom high-k dielectric layer and the interfacial layer by means of a low thermal budget drive-in anneal.

A thickness of the top high-k dielectric layer may be at least half of the thickness of the bottom high-k dielectric layer.

It is conceivable that the top high-k dielectric layer may be dimensioned such that a thickness thereof does not exceed a thickness of the bottom high-k dielectric layer. Thus, a thickness of the top high-k dielectric layer may be at least half of the thickness of the bottom high-k dielectric layer and smaller or equal to the thickness of the bottom high-k dielectric layer.

By way of example, should the bottom high-k dielectric layer be 1.2 nm, it follows that the top high-k dielectric layer may be 0.6 nm. Thus, there may be provided a total thickness being 1.8 nm. Such a ratio between the top high-k dielectric layer and the bottom high-k dielectric layer provides a high-k dielectric layer having such a total thickness that the gate leakage current may be reduced while still being sufficiently thin so as to allow further scaling of the semiconductor device. By way of another example, the bottom high-k dielectric layer may be 1.0 nm and the top high-k dielectric layer may be 1.2 nm.

It is also conceivable that the thickness of the top high-k dielectric layer may be at least the same as the thickness of the bottom high-k dielectric layer.

The first anneal may be performed at a first annealing temperature in a range of 700 °C to 900 °C.

This temperature range ensures that a large amount of metal atoms may diffuse into the interface between the bottom high-k dielectric layer and the interfacial layer. By way of example, the temperature range may be in a range of 820 °C to 880 °C. By way of another example, the temperature range may be in a range of 840 °C to 860 °C.

The first annealing temperature may be maintained during a first annealing time, such that a product of the first annealing temperature and the first annealing time is less than 34000 s°C.

Thus, there is provided a relatively low thermal budget drive-in anneal that allows for a large amount of metal atoms to diffuse into the interface between the bottom high-k dielectric layer and the interfacial layer, while minimizing crystallisation of the dielectric layers. A thermal budget of 34000 s°C may imply an annealing temperature being 850 °C and an annealing time of 40 seconds. Alternatively, the first annealing temperature may be in the range of 700 °C to 900 °C with a thermal budget below 34000 s°C.

The first diffusion source layer may comprise:
lanthanum oxide, wherein the metal atoms of the first diffusion source layer are lanthanum atoms; or
aluminium oxide, wherein the metal atoms of the first diffusion source layer are aluminium atoms.

Lanthanum (La) and aluminium (Al) are suitable materials for dipole formation in semiconductor devices. Lanthanum may be used for Vt reduction for n-type field effect transistor (NFET) devices. Aluminium may be used for Vt reduction for p-type field effect transistor (PFET) devices.

The method may further comprise:
performing a second anneal in an atmosphere comprising oxygen, wherein:
the second anneal is performed after removing the first capping layer and prior to forming the top high-k dielectric layer, with the bottom high-k dielectric layer exposed to the atmosphere comprising oxygen.

In order to improve the surface morphology e.g. by reducing defects of the bottom high-k dielectric layer, after having removed the first capping layer but prior to having formed the top high-k dielectric layer, a second anneal may be performed. The second anneal may further facilitate any subsequent processing steps including forming the top high-k dielectric layer on top of the bottom high-k dielectric layer. It has been discovered by the inventors that by improving the surface morphology of the layers of the layer stack, a reduced gate leakage current is achieved. The second annealing may also further improve the formation of the interface dipole and thereby shift the EWF even further.

It may in this context be noted that by forming the top high-k dielectric layer on top of the bottom high-k dielectric layer, the top high-k dielectric layer need not be in direct contact with the bottom high-k dielectric layer. For instance, there may still be a residual layer of the first diffusion source layer on top of the bottom high-k dielectric layer.

The second anneal may be performed at a second annealing temperature in a range of 600 °C to 800 °C.

This temperature range ensures that the surface morphology of the layers of the layer stack is improved and that any defects are reduced. By way of example, the temperature range may be in a range of 700 °C to 800 °C. By way of another example, the temperature may be 720°C to 780°C. By way of yet another example, the temperature may be more or less 750°C.

An oxygen partial pressure during the second anneal may be below 100 torr.

By ensuring that the oxygen partial pressure is below 100 torr, the second annealing may result in a layer stack with a comparably low density of defects while ensuring that the risk of regrowth of the interfacial layer is minimal, or at least reduced. The oxygen partial pressure is preferably less than 10 torr. For example, the oxygen partial pressure may be in the range of 5-10 torr. By way of another example, the oxygen partial pressure may be in the range of 7-8 torr.

It may in this context be noted that the second anneal may alternatively be performed with an oxygen total pressure being in the range of the above-mentioned values.

The second annealing temperature may be maintained during a second annealing time, the second annealing time being less than 5 seconds.

Thus, a second annealing may be performed with a low thermal budget. As such, crystallisation of the dielectric layers may be obviated while ensuring that defects in the layer stack are reduced. By way of example, the second annealing time may be in the range of 1 second to 2 seconds. For instance, the second annealing time may be 1.5 seconds.

The method may comprise, before performing the first anneal:
removing the first capping layer and the first diffusion source layer in a region, such that the bottom high-k dielectric layer becomes exposed in the region;
forming a second diffusion source layer, being a layer comprising metal atoms, on top of the bottom high-k dielectric layer in the exposed region;
forming a second capping layer on top of the second diffusion source layer;

wherein the first anneal is performed such that metal atoms of the second diffusion source layer diffuse into the bottom high-k dielectric layer in the exposed region;
wherein both the first and second capping layers are removed after the first anneal;
wherein metal atoms of the first diffusion source layer and metal atoms of the second diffusion source layer are configured to, when diffused into the bottom high-k dielectric layer, induce dipole moments of opposite directions.

In other words, the metal atoms of the first diffusion source layer may decrease the effective work function to the conduction band edge of the underlying semiconductor layer portion, while the metal atoms of the second diffusion source layer may increase the effective work function to the valence band-edge of the underlying semiconductor layer portion.

Depending on how the semiconductor device is to be formed, it is conceivable that the metal atoms of the first diffusion source layer may increase the effective work function to the valence band-edge of the underlying semiconductor layer portion, while the metal atoms of the second diffusion source layer may decrease the effective work function to the conduction band edge of the underlying semiconductor layer portion.

Thus, there may be provided a gate dielectric for a complementary metal oxide semiconductor field effect transistor (CMOSFET) comprising an NFET and a PFET having a reduced gate leakage current and a low Vt.

To exemplify, consider the situation where the metal atoms of the first diffusion source layer are La atoms and the metal atoms of the second diffusion source layer are Al atoms. In this case, the gate dielectric in the region that was exposed before forming the second diffusion source layer may have an interface dipole region comprising La and be a gate dielectric suitable for a NFET while the remaining gate dielectric may have an interface dipole region comprising Al and be a gate dielectric suitable for an PFET.

According to a second aspect of the invention, there is provided a gate dielectric for a semiconductor device, the gate dielectric comprising:
an interfacial layer, being a layer of dielectric material, arranged on top of a semiconductor layer;
a bottom high-k dielectric layer arranged on top of the interfacial layer, the interfacial layer being in-between the bottom high-k dielectric layer and the semiconductor layer, the interfacial layer and the bottom high-k dielectric layer comprising different materials;
a top high-k dielectric layer, being a layer of high-k dielectric material arranged on top of the bottom high-k dielectric layer;
metal atoms having a distribution, the distribution having a peak at or below a boundary between the interfacial layer and the bottom high-k dielectric layer.

All advantages, features and subject-matter discussed with reference to the method according to the first aspect of the invention may apply also to (and/or be combinable with) the gate dielectric according to the second aspect of the invention, and vice versa. For example, the discussion of the layer materials and the layer thicknesses of the method for forming a gate dielectric may apply correspondingly to the layers of the gate dielectric formed by the method.

It may be noted that the gate dielectric is preferably provided for a logic semiconductor device, although it may also be provided for other types of devices such as memory devices.

Preferably, the metal atoms of the first diffusion source layer are of a rare-earth element, such as lanthanum or dysprosium. Preferably, the metal atoms are lanthanum atoms. The first diffusion source layer may form part of an NFET.

Furthermore, the metal atoms of the second diffusion source layer is preferably aluminium, although other types of metal suitable to form an interface dipole are conceivable. The second diffusion source layer may form part of a PFET. The NFET and the PFET may be arranged side-by-side and thus form a CMOSFET.

The distribution of the aluminium metal atoms may have a peak at or below the interface between the interfacial layer and the bottom dielectric layer such that an atomic concentration of the aluminium atoms is above 5 at%. Such atomic concentrations may ensure that a sufficient EWF shift is obtained and thereby a low threshold voltage is obtained. Such atomic concentrations also imply that a large amount of metal atoms have diffused into the bottom high-k dielectric layer. This is made possible by the first and second aspects of the invention.

The top high-k dielectric layer may be substantially free from metal atoms.

The first anneal is performed prior to forming the top high-k dielectric layer. Thus, the metal atoms from the first and second diffusion source layers will diffuse into the bottom high-k dielectric layer such that a distribution will be formed therein. A second anneal may also be performed prior to forming the top high-k dielectric. However, the second anneal will have a minor effect on the interface dipole. Since the first and second anneals are performed prior to forming the top high-k dielectric layer, it is implied that the top high-k dielectric layer will be substantially free from metal atoms. Thanks to forming the bottom and top high-k dielectric layers in two steps, such a configuration of the gate dielectric is possible.

It is further implied that should any subsequent processing steps such as dopant activation or any other anneals be performed after having formed the top high-k dielectric layer, such steps may have minor effects on the interface dipole, and furthermore any diffusion of metal atoms in the top high-k dielectric layer may be kept at a minimum concentration such that should any distribution be formed therein it will be insignificant. In other words, the top high-k dielectric layer may be substantially free from metal atoms.

It is also implied that since the bottom high-k dielectric layer and the top high-k dielectric layer are formed at different points in time, any distribution formed therein may have a substantial transition. Hence, any spectroscopic analysis or the like of the high-k dielectric layer, e.g. Energy-dispersive X-ray spectroscopy (EDX), may reveal that there is provided two distinct layers (a bottom layer and a top layer) of the high-k dielectric layer.

In this context it may be noted that the bottom high-k dielectric layer and the top high-k dielectric layer may form a homogeneous dielectric layer having a substantially uniform composition although each of the bottom high-k dielectric layer and the top high-k dielectric layer may have certain distribution of metal atoms.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.

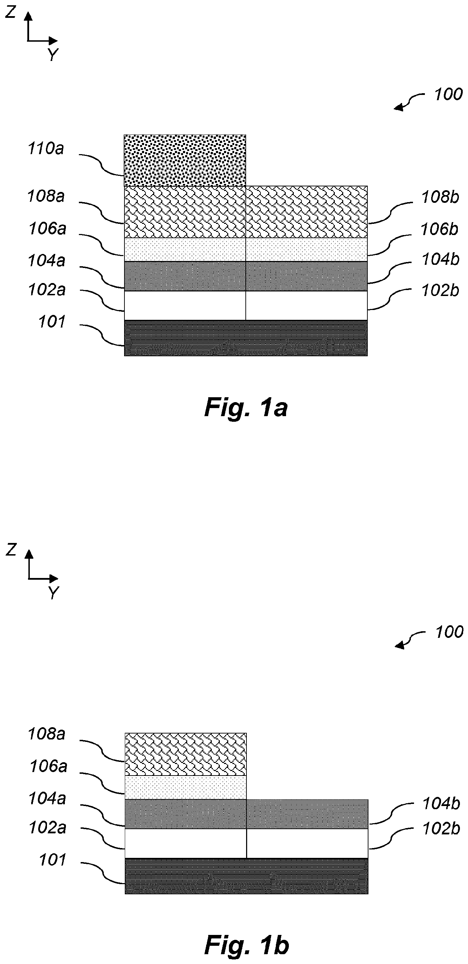

Figs. 1a-g illustrate the gate dielectric formation steps of a method applied to a semiconductor device in a schematically depicted cross-sectional view.

### DETAILED DESCRIPTION

In the following the formation of a gate dielectric will be exemplified in the context of a gate dielectric for a CMOSFET. It should be understood that the figures schematically represent the semiconductor device and that the respective gate dielectric of the NFET and PFET of the CMOSFET may be for instance electrically insulated from each other by e.g. a dielectric wall.

Referring now to Fig. 1a, an initial formation of the gate dielectric 100 is illustrated. The gate dielectric 100 may be formed on a semiconductor layer 101. The substrate 101 may be a conventional semiconductor substrate suitable for e.g. complementary metal-oxide semiconductor (CMOS). The substrate 101 may for instance be a semiconductor bulk substrate such as a Si substrate, a germanium (Ge) substrate or a silicon-germanium (SiGe) substrate. Other examples include a semiconductor-on-insulator (SOI) type of substrate such as a Si-on-insulator substrate, a Ge-on-insulator substrate or a SiGe-on-insulator substrate.

By layer stack it is herein meant the layers of the gate dielectric 100.

Whenever there is a reference to a layer being formed, this is preferably performed using conventional semiconductor fabrication technology, such as metalorganic chemical vapour deposition (MOCVD), physical vapor deposition (PVD), atomic layer deposition (ALD), thin-film deposition, or the like.

In the figures, directions Y and Z indicate a horizontal and a vertical direction, respectively. Direction Z indicates a vertical or bottom-up direction (normal to the substrate 101). The figures illustrate a respective cross section of a center view parallel to the YZ-plane.

The method may further comprise planarizing a top surface of the substrate 101. A smooth top surface of the substrate 101 may thus be formed. As such, the substrate 101 may provide a flat top surface which facilitates forming a layer stack on top of the substrate 101. The planarizing of the substrate 101 may, for instance, be achieved by chemical mechanical polishing (CMP).

The method further comprises depositing an interfacial layer 102a-b on the substrate 101. The interfacial layer 102a-b forms a layer arranged on a surface of the substrate 101 and parallel therewith. The interfacial layer 102a-b is configured to be arranged in contact with the substrate 101. It is, however, conceivable that there may be arranged an intermediate layer between the interfacial layer 102a-b and the substrate 101.

The interfacial layer 102a-b is a layer of dielectric material. The interfacial layer 102a-b may comprise silicon oxide (or silicon dioxide) and/or silicon oxynitride. Alternatively, or additionally, the interfacial layer 102a-b may comprise hafnium oxide, hafnium silicate, zirconium oxide, zirconium silicate, aluminium oxide, titanium oxide, yttrium oxide, or the like.

The method further comprises forming a bottom high-k dielectric layer 104a-b, hereinafter referred to as the bottom dielectric layer 104a-b, on top of the interfacial layer 102a-b. Thus, the interfacial layer 102a-b is arranged between the bottom dielectric layer 104-b and the semiconductor substrate 101. The bottom dielectric layer 104a-b is preferably arranged on the interfacial layer 102a-b such that a physical interface therebetween is formed. However, it is also conceivable that there may be arranged one or more additional interfacial layers between the interfacial layer 102a-b and the bottom dielectric layer 104a-b. In such a case, the bottom dielectric layer 104a-b may form an interface with an upper most interfacial layer.

The bottom dielectric layer 104a-b is a layer of dielectric material. The bottom dielectric layer 104a-b may comprise hafnium oxide and/or zirconium oxide. Alternatively, or additionally, the bottom dielectric layer 104a-b may comprise hafnium oxide, hafnium silicate, zirconium oxide, zirconium silicate, aluminium oxide, titanium oxide, yttrium oxide, and/or any other high-k materials.

The interfacial layer 102a-b and the bottom dielectric layer 104a-b may comprise different materials such that a distinct interface is formed therebetween.

A thickness of the bottom dielectric layer 104a-b may be below 1.5 nm. By way of example, the bottom dielectric layer 104a-b may be below 1.2 nm, or below 1.0 nm. In general, the thickness of the bottom dielectric layer 104a-b may be between 0.5 nm and 1.5 nm, e.g. 1.0 nm.

The method further comprises forming a first diffusion source layer 106a-b on top of the bottom dielectric layer 104a-b. The first diffusion source layer 106a-b is a layer comprising metal atoms. The metal atoms may comprise dipole formation atoms configured to form an interface dipole. The first diffusion source layer 106a-b may comprise lanthanum oxide. The metal atoms of the first diffusion source layer 106a-b may thus be lanthanum atoms.

Alternatively, the first diffusion source 106a-b layer may comprise aluminium oxide. The metal atoms of the first diffusion source layer 106a-b may thus be aluminium atoms.

The method further comprises forming a first capping layer 108a-b on top of the first diffusion source layer 106a-b. The first capping layer 108a-b may be formed of a layer comprising TiN.

On top of the first capping layer 108a-b, a masking layer 110a may be formed. The masking layer 110a may be a hard mask. The masking layer 110a may be a Spin-on-Carbon (SoC) layer. Alternatively, the masking layer 110a may be a Spin-on-Glass (SoG) layer. The masking layer 110a may prepare the layer stack for subsequent processing steps.

Any (subsequent) formation of any features of the gate dielectric 100 may involve patterning steps, such as using lithography and etching, which may be provided by equipment readily available at the semiconductor fabrication plant.

Referring now to Fig. 1b, the method may further comprise removing, at least partially by means of e.g. wet etching, the first capping layer 108b and the first diffusion source layer 106b, at least partially, in a region, such that the bottom dielectric layer 104b becomes exposed in that region. In the figure, the masking layer 110a has also been removed. It may be noted that the removal may result in a portion of the remaining first capping layer 108 being removed such that a height of the first capping layer 108 is reduced.

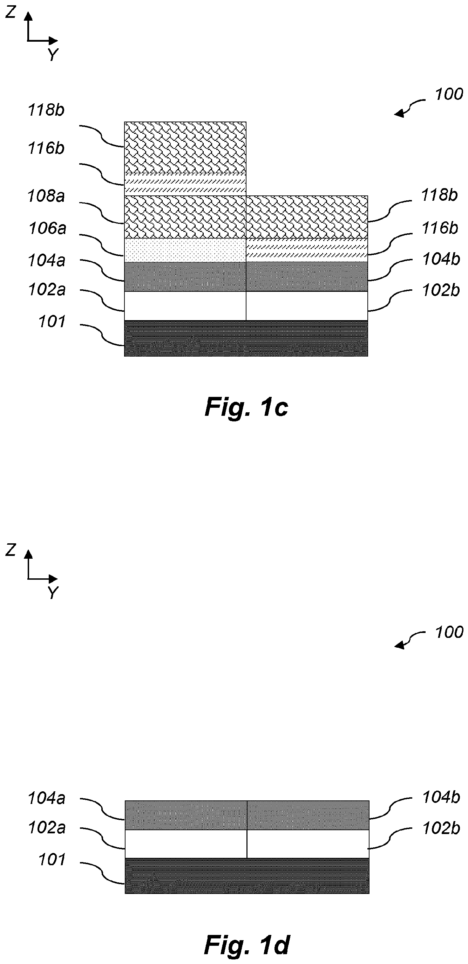

Referring now to Fig. 1c, the method may further comprise forming a second diffusion layer source 116b, being a layer comprising metal atoms, on top of the bottom dielectric layer 104b in the exposed region. It is conceivable that the second diffusion layer 116b may additionally extend over any unremoved portions of the first capping layer 108b.

It may be noted that the second diffusion source layer 116b may also be formed by means of e.g. an anisotropic deposition such that there is also formed a second diffusion source layer 116b formed on the remaining first capping layer 108a. As such, the gate dielectric 100 may at this stage form a staggered structure.

The remaining first diffusion source layer 106a and the second diffusion layer source 116b may be arranged side-by-side on an upper surface of the bottom dielectric layer 104b and coplanar therebetween. Thus, the first diffusion source layer 106a and the second diffusion layer source 116b may be associated with different areas of the bottom dielectric layer 104a-b.

The second diffusion source layer 108b is a layer comprising metal atoms. The second diffusion source layer 108b may comprise lanthanum oxide. The metal atoms of the second diffusion source layer 108b may thus be lanthanum atoms.

Alternatively, the second diffusion source 108b layer may comprise aluminium oxide. The metal atoms of the second diffusion source layer 10b may thus be aluminium atoms. It may be noted that the first diffusion source layer 106a-b and the second diffusion source layer 108b are layers comprising different metal atoms. That is, the first diffusion source layer 106a-b may be a layer comprising lanthanum oxide and thereby the metal atoms are lanthanum atoms. At the same time, the second diffusion source layer 108b may be a layer comprising aluminium oxide and thereby the metal atoms are aluminium atoms. This enables the provision of a gate dielectric for a semiconductor device being, for instance, a CMOSFET. That is, that side or portion of the gate dielectric 100 that comprises lanthanum metals atoms may be configured to form part of an NFET. That side or portion of the gate dielectric 100 that comprises aluminium metals atoms may be configured to form part of a PFET.

It may be noted that both the first diffusion source layer 106a and the second diffusion source layer 116b need not necessarily comprise lanthanum oxide and aluminium oxide, respectively. On the contrary, said layers may comprise any material that may enable the formation of an interface dipole. For instance, other types of rare-earth elements such as dysprosium or its oxide may be incorporated into the diffusion source layers instead of lanthanum or its oxide.

The method may further comprise forming a second capping layer 118b on top of the second diffusion layer 116b.

The method further comprises performing a first anneal such that metal atoms of the first diffusion source layer 106a and the second diffusion source layer 116b diffuse into the bottom dielectric layer 104a-b. The first anneal may be performed subsequent to forming the bottom dielectric layer 104a-b. The metal atoms may thus diffuse into an interface between the interfacial layer 102a-b and the bottom dielectric layer 104a-b and thereby form an induced dipole region.

The metal atoms of the first diffusion source layer 106a and the second diffusion source layer 116b may be configured to induce dipole moments of opposite directions. By doing this, the threshold voltage of the semiconductor device may be reduced. It is implied that the first anneal is performed such that the metal atoms of the second diffusion source layer 116b diffuse into the bottom dielectric layer 104b in the exposed region.

It may be noted that the each of the first diffusion source layer 106a and the second diffusion source layer 116b need not fully diffuse into the bottom dielectric layer 104a-b. In fact, a residual layer of the first diffusion source layer 106a and the second diffusion source layer 116b may remain on top of the bottom dielectric layer 104a-b.

The metal atoms may have a certain distribution. The distribution may have a peak at or below a boundary between the interfacial layer 102a-b and the bottom dielectric layer 104a-b. More specifically, the distribution of the aluminium metal atoms may have a peak at or below the interface between the interfacial layer 102a-b and the bottom dielectric layer 104a-b such that an atomic concentration is above 5 at%.

The first anneal may be performed at a first annealing temperature in a range of 700 °C to 900 °C. By way of example, the temperature range may be in a range of 820 °C to 880 °C. By way of another example, the temperature range may be in a range of 840 °C to 860 °C.

The first annealing temperature may be maintained during a first annealing time, such that a product of the first annealing temperature and the first annealing time is less than a thermal budget of 34000 s°C. The product of the annealing temperature and the annealing time may be expressed as the thermal budget. By way of example, the first annealing temperature may be between 700 s°C and 900 s°C while the thermal budget is below 34000 s°C. The thermal budget may be even lower during the drive-in anneal in order to reduce prevent further crystallization of the gate dielectric and thereby reduce the gate leakage current even further. The thermal budget may be 17000 s°C. This implies that the annealing temperature may be 850 s°C and the annealing time may be 20 seconds.

Referring now to Fig. 1d the method further comprises removing the first capping layer 108a and the second capping layer 118b after the first anneal. Should any residual layer of the first diffusion source layer 106a and the second diffusion source layer 116b remain on top of the bottom dielectric layer 104a-b after the first anneal, then these are preferably removed as well. The removal of said layers may be performed by means of wet chemistry.

In order to improve the surface morphology after having removed the first capping layer 108a and the second capping layer 118b, the layer stack may be planarized with CMP. It may be noted that CMP may be used to remove any residual layers on top of the bottom dielectric layer 104a-b and subsequently planarize the layer stack and thus improve the surface morphology.

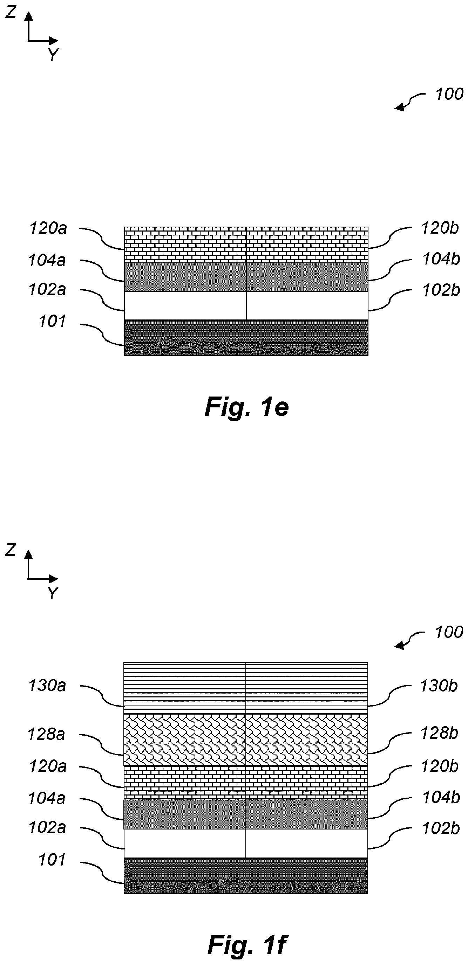

Referring to Fig. 1e, the method further comprises forming, after removing the first capping layer 108a and the second capping layer 118b, a top high-k dielectric layer 120a-b, hereinafter referred to as the top dielectric layer 120a-b, on top of the bottom dielectric 104a-b. The top dielectric layer 120a-b may be formed on any residual portions of the first capping layer 108a and the second capping layer 118b.

The top dielectric layer 120a-b may be a layer formed of the same material as the bottom dielectric layer 104a-b so as to form a homogeneous dielectric layer having a uniform composition. That is, the top dielectric layer 120a-b may comprise hafnium oxide and/or zirconium oxide. Alternatively, or additionally, the bottom dielectric layer 104a-b may comprise hafnium oxide, hafnium silicate, zirconium oxide, zirconium silicate, aluminium oxide, titanium oxide, yttrium oxide, and/or any other high-k materials.

Alternatively, it is conceivable that the bottom dielectric layer 104a-b may form a layer comprising lanthanum hafnium oxide and the top dielectric layer 120a-b may form a layer of pure hafnium oxide.

A thickness of the top dielectric layer 120a-b may, for instance, be 1.2 nm.

A thickness of the top dielectric layer 120a-b may be at least half of the thickness of the bottom dielectric layer 104a-b.

Referring now to Fig. 1f, the method may further comprise forming a third capping layer 128a-b on top of the top dielectric layer 120a-b. The third capping layer 128a-b may be a layer comprising TiN.

The method may further comprise forming an electrical contact element 130a-b on top of the third capping layer 128a-b. The electrical contact element 130a-b may be formed of a metal with high electrical conductivity, such as copper, aluminium, or silver. Alternatively, the electrical contact element 130a-b may be formed of a semiconductor material comprising, for instance, amorphous silicon (aSi) or polycrystalline silicon (poly-Si).

The electrical contact element 130a-b may be arranged on top of the third capping layer 128a-b. However, this does not imply that the electrical contact element 130a-b necessarily needs to be in direct physical contact with the third capping layer 128a-b. On the contrary, one or more layers may be interposed between the third capping layer 128a-b and the electrical contact element 130a-b such that electrical contact is provided via at least one intermediate layer.

The electrical contact element 130a-b may form a gate electrode.

It is conceivable that the third capping layer 128a-b may form part of the electrical contact element 130a-b. As such, the third capping layer 128a-b and the electrical contact element 130a-b may together form a gate electrode.

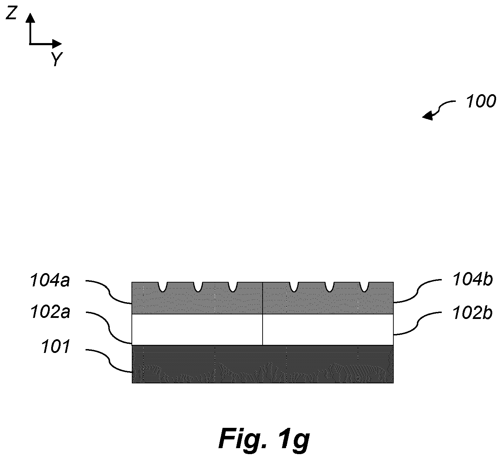

As best seen in Fig. 1g, the removal of the first capping layer 108a and the second capping layer 118b after the first anneal may result in defects in the bottom dielectric layer 104a-b. These defects may manifest themselves as pitting defects and are illustrated as holes in an upper surface of the bottom dielectric layer 104a-b. Pitting defects may have a detrimental effect to the gate leakage current and thereby the performance of the semiconductor device. In order to reduce the defects in the bottom dielectric layer 104a-b and thereby improve the performance of the semiconductor device, the method may further comprise performing a second anneal in an atmosphere comprising oxygen. The second anneal may be performed after removing the first capping layer 108a and the second capping layer 118b and prior to forming the top dielectric layer 120a-b with the bottom dielectric layer 104a-b exposed to the atmosphere comprising oxygen.

The second anneal may be performed at a second annealing temperature in a range of 600 °C to 800 °C. For instance, the second annealing temperature may be in the range of 700 °C to 800 °C.

An oxygen partial pressure during the second anneal may be below 100 torr. By ensuring that the oxygen partial pressure is below 100 torr, the second annealing may result in a layer stack with a comparably low density of defects while ensuring that the risk of regrowth of the interfacial layer 102a-b is minimal, or at least reduced.

The oxygen partial pressure is preferably less than 10 torr. For example, the oxygen partial pressure may be in the range of 5-10 torr. By way of another example, the oxygen partial pressure may be in the range of 7-8 torr.

It may in this context be noted that the second anneal may alternatively be performed with an oxygen total pressure being in the range of the above-mentioned values.

For the second anneal, the second annealing temperature may be maintained during a second annealing time being less than 5 seconds. Thus, a second annealing may be performed with a low thermal budget. As such, crystallisation of the dielectric layers may be reduced while ensuring that defects in the layer stack are reduced. By way of example, the second annealing time may be in the range of 1 second to 2 seconds. For instance, the second annealing time may be 1.5 seconds. By way of yet another example, the second annealing may be performed at an annealing temperature of 750 °C, at an annealing time of 1.5 seconds, and at an oxygen total pressure of 7.6 torr.

The layers of the semiconductor device as illustrated in the figures may be formed of the materials as discussed in various levels above. Preferably, the interfacial layer 102a-b is formed of SiO₂, the bottom dielectric layer 104a-b of HfO₂, the top dielectric layer 120a-b of HfO₂, the metal atoms forming part of the NFET of La atoms (the first diffusion source layer 106a may be La₂O₃), and the metal atoms forming part of the PFET of Al atoms (the second diffusion source layer 116b may be Al₂O₃).

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a gate dielectric (100) for a semiconductor device, the method comprising:
forming an interfacial layer (102a-b), being a layer of dielectric material, on top of a semiconductor layer (101);
forming a bottom high-k dielectric layer (104a-b) on top of the interfacial layer (102a-b), the interfacial layer (102a-b) being in-between the bottom high-k dielectric layer (104a-b) and the semiconductor layer (101), the interfacial layer (102a-b) and the bottom high-k dielectric layer (104a-b) comprising different materials;
forming a first diffusion source layer (106a-b), being a layer comprising metal atoms, on top of the bottom high-k dielectric layer (104a-b);
forming a first capping layer (108a-b) on top of the first diffusion source layer (106a-b);
performing a first anneal such that metal atoms of the first diffusion source layer (106a-b) diffuse into the bottom high-k dielectric layer (104a-b);
removing the first capping layer (108a-b) after the first anneal; and
forming, after removing the first capping layer (108a-b), a top high-k dielectric layer (120a-b) on top of the bottom high-k dielectric layer (104a-b).

2. The method according to claim 1, wherein the interfacial layer (102a-b) comprises silicon oxide and/or silicon oxynitride.

3. The method according to any one of the preceding claims, wherein the bottom and/or top high-k dielectric layer (104a-b, 120a-b) comprises hafnium oxide or zirconium oxide

4. The method according to any one of the preceding claims, wherein a thickness of the bottom high-k dielectric layer (104a-b) is below 1.5 nm.

5. The method according to any one of the preceding claims, wherein a thickness of the top high k-dielectric layer (120a-b) is at least half of the thickness of the bottom high-k dielectric layer(104a-b).

6. The method according to any one of the preceding claims, wherein the first anneal is performed at a first annealing temperature in a range of 700 °C to 900 °C.

7. The method according to claim 6, wherein, for the first anneal, the first annealing temperature is maintained during a first annealing time, such that a product of the first annealing temperature and the first annealing time is less than 34000 s°C.

8. The method according to any one of the preceding claims, wherein the first diffusion source layer (106a-b) comprises:
lanthanum oxide, wherein the metal atoms of the first diffusion source layer (106a-b) are lanthanum atoms; or
aluminium oxide, wherein the metal atoms of the first diffusion source layer (106a-b) are aluminium atoms.

9. The method according to any one of the preceding claims, further comprising:
performing a second anneal in an atmosphere comprising oxygen, wherein:
the second anneal is performed after removing the first capping layer (108a-b) and prior to forming the top high-k dielectric layer (120a-b), with the bottom high-k dielectric layer (104a-b) exposed to the atmosphere comprising oxygen.

10. The method according to claim 9, wherein the second anneal is performed at a second annealing temperature in a range of 600 °C to 800 °C.

11. The method according to any one of claims 9-10, wherein an oxygen partial pressure during the second anneal is below 100 torr.

12. The method according to any one of claims 9-11, wherein, for the second anneal, the second annealing temperature is maintained during a second annealing time, the second annealing time being less than 5 seconds.

13. The method according to any one of the preceding claims,
the method comprising, before performing the first anneal:
removing the first capping layer (108b) and the first diffusion source layer (106b) in a region, such that the bottom high-k dielectric layer becomes (104a-b) exposed in the region;
forming a second diffusion source layer (116b), being a layer comprising metal atoms, on top of the bottom high-k dielectric layer (104a-b) in the exposed region;
forming a second capping layer (118b) on top of the second diffusion source layer (116b);
wherein the first anneal is performed such that metal atoms of the second diffusion source layer (116b) diffuse into the bottom high-k dielectric layer (104a-b) in the exposed region;
wherein both the first and second capping layers (108a, 118b) are removed after the first anneal;
wherein metal atoms of the first diffusion source layer (106a) and metal atoms of the second diffusion source layer (116b) are configured to, when diffused into the bottom high-k dielectric layer (104a-b), induce dipole moments of opposite directions.

14. A gate dielectric (100) for a semiconductor device, the gate dielectric (100) comprising:
an interfacial layer (102a-b), being a layer of dielectric material, arranged on top of a semiconductor layer (101);
a bottom high-k dielectric layer (104a-b) arranged on top of the interfacial layer (102a-b), the interfacial layer (102a-b) being in-between the bottom high-k dielectric layer (104a-b) and the semiconductor layer (101), the interfacial layer (102a-b) and the bottom high-k dielectric layer (104a-b) comprising different materials;
a top high-k dielectric layer (120a-b), being a layer of high-k dielectric material arranged on top of the bottom high-k dielectric layer (104a-b);
metal atoms having a distribution, the distribution having a peak at or below a boundary between the interfacial layer (102a-b) and the bottom high-k dielectric layer (104a-b).

15. The gate dielectric according to claim 14, wherein the top high-k dielectric layer (120a-b) is substantially free from metal atoms.
